# EUROPEAN PATENT APPLICATION

(11) **EP 2 383 368 A2**
(43) Date of publication of application: **02.11.2011**
(21) Application number: 11175652.4
(22) Date of filing: 13.04.2007
(51) Int. Cl.: C23C 16/513, C23C 16/54, H01L 31/20

(54) **Plasma deposition apparatus and method for making solar cells**

(30) Priority: 14.04.2006 US 791883 P; 22.06.2006 US 815575 P
(62) Divisional of application: 07775287.1
(71) Applicant: Silica Tech, LLC, White Plains, NY 10671 (US)
(72) Inventor: Aslami, Mohd. A., Sturbridge, MA 01566 (US); Wu, Dau, Fallbrook, CA 92028 (US)
(74) Representative: Manley, Nicholas Michael

(57) **Abstract**

A plasma deposition apparatus for making solar cells comprising a conveyor having a longitudinal axis for supporting at least one substrate; at least two modules each having at least one plasma torch for depositing a layer of a reaction product on the at least one substrate, the at least one plasma torch located a distance from the at least one substrate; a chamber for containing the conveyor and the at least two modules; and an exhaust system. In another embodiment, the plasma deposition apparatus for making solar cells comprises: means for supporting a substrate; means for supplying reactants; plasma torch means for depositing a product on the substrate, the plasma torch means located a distance from the substrate; and means for oscillating the plasma torch means relative to the substrate.

## Description

### CROSS-REFERENCES TO RELATED APPLICATIONS

This application claims the benefit of U.S. Provisional Application No. 60/791,883, filed 14 April 2006 and U.S. Provisional Application No. 60/815,575, filed 22 June 2006. The entireties of these applications are incorporated herein by reference.

### FIELD OF THE INVENTION

The present invention relates to a process for making photovolraic modules or solar cells.

### PROBLEM

As oil prices have continued to increase and other energy sources remain limited, there is increasing pressure on global warming from the emissions of burning fossil fuel. There is a need to find and use alternative energy sources, such as solar energy because it is free and does not generate carbon dioxide gas. To that end, many nations are increasing their investment in safe and reliable long-term sources of power, particularly "green" or "clean" energy sources. Nonetheless, while the solar cell also known as a photovoltaic cell or modules, has been developed for many years, it had very limited usage because the cost of manufacturing these cells or modules is still high, making it difficult to compete with energy generated by fossil fuel.

Presently, the single crystal silicon solar cell has the best energy conversion efficiency but it also has the highest manufacture cost. Alternatively, thin-film silicon while it does not have the same high efficiency of a single crystal cell, it is much cheaper to produce. Therefore, it has the potential for low cost photovoltaic power generation. Other types of thin-film materials such as copper indium gallium diselenide ("CIGS") also showed promising results with efficiencies approaching the single crystal silicon, at a lower cost, but still not low enough to compete effectively with fossil fuel.

Part of the reason for the manufacturing expense is that the deposition rates of these processes are low and time consuming. For example, the typical process of plasma glow discharge of silane in the presence of a high concentration of hydrogen gas to form the desired silicon layer achieves a deposition rate of approximately 20 A/s or 0.12 microns/minute. For another example, the typical plasma chemical vapor deposition ("CVD") method for forming high quality i-type silicon layer achieves a reported deposition rate of approximately 15 A/s or 0.09 microns/minute. In yet another example, the typical chemical vapor transport ("CVT") method, which uses iodine vapor as a transport medium to deposit polycrystalline silicon, achieved film growth rates up to approximately 3 microns/minute.

Similar to silicon solar cell technologies, efforts have been made to manufacture CIGS type solar cells using different techniques. In one attempt, CIGS type solar cells are manufactured in a two-stage process using various precursor structures, which is known as a the selenization technology. Attempts have been made to improve on the selenization technology. In one such attempt, a two-stage process using the magnetron sputtering technique with a conveyor system to make a thin film is known. In another attempt, a vapor-phase recrystallisation process is used to make CIGS films. The recrystallization process was used as the second step of the process and it replaced the selenization process as taught by previous arts. In yet another attempt, CIGS film was manufactured using an electrochemical deposition in a solution that was followed by physical vapor deposition. This technology produced a CIGS type solar cell with an overall conversion efficiency of 13.6%.

In addition to the efforts to efficiently manufacture the types of solar cells mentioned above, additional efforts have been expended to efficiently manufacture other types of solar cells, such as multi-junction solar cells. These types of solar cells have the construction of multiple layers with different materials. The different materials have different bandgaps and they will absorb various wavelengths of the solar energy. Thus, these types of solar cells cover a broader solar spectrum and may improve the efficiency of the solar cell. Some efforts have been expended to efficiently produce these types of solar cells. In one such effort multi-junction solar cells are manufactured with amorphous silicon and copper indium diselenide ("CIS") and their alloys. However; this manufacturing process is very complicated and needs different kinds of equipment, thus making it expensive to produce these types of solar cells. Some examples for producing layers of CIS or CIGS include depositing these layers by way of solution growth, sputtering, or evaporation. Also, layers of silicon are deposited by way of enhanced plasma chemical vapor deposition.

As mentioned above, to make thin film solar cells requires a deposition technique to deposit the required layers, and the most effective way to lower the manufacturing cost is to increase the deposition rate. The best reported deposition rate for Plasma-Enhanced Chemical Vapor Deposition ("PECVD") is about 5 A/sec, and the deposition rate for plasma glow-discharge of silane is 20 A/sec.

Furthermore, in addition to slow deposition rates, another slow process step found commonly in the manufacture of solar cells involves the incorporation of p-type and n-type dopants to form the p-n junction of the semiconductor material. This step is normally done in extremely slow diffusion furnaces after the thin-film layer has already been deposited, thus further slowing down the overall process of efficiently producing solar cells.

In addition, with regard to the process of making CIGS thin films, the process usually uses two or more stages. The purpose for the additional steps of the process is to deposit or adjust these elements to achieve the desired or optimum composition ratios and phase structure of the GIGS thin films. In the fist step, various techniques have been used for build-up the required thickness of film with the concentration ratios being relatively close to the designed value. The combination of these steps inhibits an efficient manufacturing process for making CIGS thin films.

Information relevant to attempts to address these problems can be found in the U.S. Patent Nos. 5,646,050 issued 08 Jul 1997 to Li, et al.; 5,942,049 issued 24 Aug 1999 to Li. et al.; 6,100,466 issued 08 Aug 2000 to Nishirnoto; 6,214,706 issued 10 Apr 2001 to Madan, et al.; 6,281,098 issued 28 Aug 2001 to Wang, et al.; 5,141,564 issued 25 Aug 1992 to Chen, et al.; 4,798,660 issued 17 Jan 1989 to Ermer, et al.; 4,915,745 issued 10 Apr 1990 to Pollock, et al.: 6,048,442 issued 11 Apr 2000 to Kushiya, et al.; 6,258,620 issued 10 Jul 2001 to Morel, et al.; 6,518,086 issued 11 Feb 2003 to Beck, et al.; 5,045,409 issued 03 Sep 1991 to Eberspacker, et al.; 5,356,839 issued 18 Oct 1994 to Tuttle, et al.; 5,441,897 issued 15 Aug 1995 to Noufi, et al.; 5,436,204 issued 25 Jul 1995 to Albin, et al.; 5,730,852 issued 24 Mar 1998 to Bhattacharya, et al.; 5,804,054 issued 08 Sep 1998 to Bhattacharya, et al.; 5,871,630 issued 16 Feb 1999 to Bhattacharya, et al.; 5,976,614 issued 02 Nov 1999 to Bhattacharya, et al.; 6,121,541 issued 19 Sep 2000 to Arya; and 6,368,892 issued 09 Apr 2002 to Arya.

### SOLUTION

The above-described problems are solved and a technical advance achieved by the plasma deposition apparatus and method for making solar cells disclosed in this application. The novel process uses an induction coupled plasma torch to make the thin film solar cells. It has a higher deposition rate, and it can be designed as a continuous flow process such that it can dramatically lower the manufacturing cost of the thin film. By using a conveyer system for a continuous in-line process, this process can deposit the required thin film on a substrate such as glass, flexible metal, or high temperature polymer materials.

The novel induction coupled plasma deposition process provides a measurably higher deposition rate, leading to a much lower manufacturing cost. Another major aspect of the novel plasma deposition apparatus and method for making solar cells is to simultaneously incorporate such positive and/or negative dopanting material during the thin-film deposition, thus eliminating another very slow and costly process in the manufacturing steps.

One advantage of the induction coupled plasma, torch is its very high deposition rate ("DR"). For additional efficiency and manufacturing cost savings, one or more induction coupled plasma torches can be grouped together to provide a set of induction coupled plasma torches to form the deposition module integrated with a conveyer system. It is an easy, yet versatile production system with high deposition and throughput rates.

In addition, the novel plasma deposition apparatus and method for making solar cells can easily inject the desired materials to the right deposition module and deposit the designed layer on one conveyer system as the substrate moves from one deposition module or deposition chamber onto another deposition module or deposition chamber. Alternatively, the novel plasma deposition apparatus and method for making solar cells provides for the solar cell to enter and reenter the same deposition modules as different chemicals are introduced in each cycle.

Further, when doping the thin-film by this novel plasma deposition apparatus and method for making solar cells, the direct control of the dopants distribution and a better concentration profile than the typical diffusion process is achieved. The apparatus and method can also greatly influence energy conservation efficiency and chemical and physical properties. Moreover, using a deposition process instead of diffusion process to make p-type or n-type doped thin films, not only provides better control and more uniform dopants distribution, but it also eliminates the two-step process, yielding a higher production rate.

Also, the novel plasma deposition apparatus and method for making solar cells meets the challenges of producing high quality solar cell that includes optimizing the quality i-type layer. The doped p- and n- type layers for low contact resistance, high build-in potential and high transparency to reduce unnecessary optical losses and the present novel plasma deposition apparatus and method for making solar cells accommodates such requirements.

In one feature, the novel plasma deposition apparatus and method for making solar cells can use materials that contain the constitute elements of copper, indium, gallium, and selenium that are injected into the plasma flame to form a thin layer of CIGS. In another feature, the plasma deposition apparatus and method for making solar cells can use properly designed ratios of copper, indium, gallium, and selenium to inject into the plasma, flame and form the CIGS thin film.

### BRIEF DESCRIPTION OF THE DRAWINGS

Figure 1 illustrates a cutaway side view of the plasma deposition apparatus for making solar cells according to an embodiment of the present invention;

Figure 2 illustrates a top view of the plasma deposition apparatus showing adjacent rows of plasma, deposition torches relative to a substrate according to an embodiment of the present invention;

Figure 3 illustrates a top view of the plasma deposition apparatus including a deposition chamber according to an embodiment of the present invention;

Figure 4 illustrates a top view of a plasma deposition apparatus showing adjacent rows of plasma deposition torches relative to a substrate according to another embodiment of the present invention;

Figure 5 illustrates a top view of a plasma deposition apparatus showing adjacent rows of plasma deposition torches relative to a substrate according to another embodiment of the present invention;

Figure 6 illustrates a flow diagram of a process for making solar cells according to an embodiment of the present invention;

Figure 7 illustrates a flow diagram of another process for making solar cells according to an embodiment of the present invention; and

Figure 8 illustrates a flow diagram of another process for making solar cells according to another embodiment of the present invention.

### DETAILED DESCRIPTION OF THE DRAWINGS

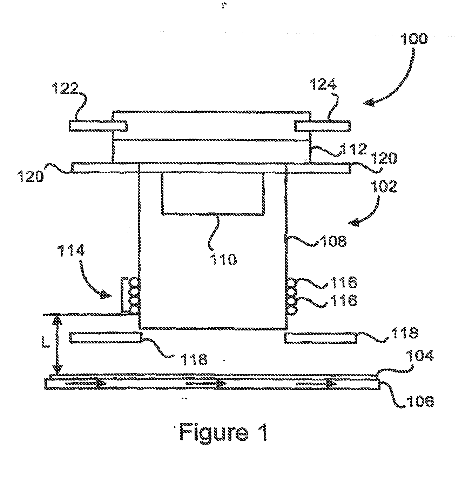

Figure 1 illustrates an embodiment 100 of a plasma deposition apparatus including an induction coupled plasma torch 102 positioned above a substrate 104 that is supported on a conveyor 106. In this embodiment, the induction coupled plasma torch 102 is aimed downward for depositing a reaction product on the substrate 104. In another embodiment, the induction coupled plasma torch 102 may be aimed or oriented in another manner or direction with respect to the substrate 104. The induction coupled plasma, torch 102 consists of two quartz tubes: an outer quartz tube 108 and a shorter inner quartz tube 110, which are shown to be attached to a stainless steel chamber 112.

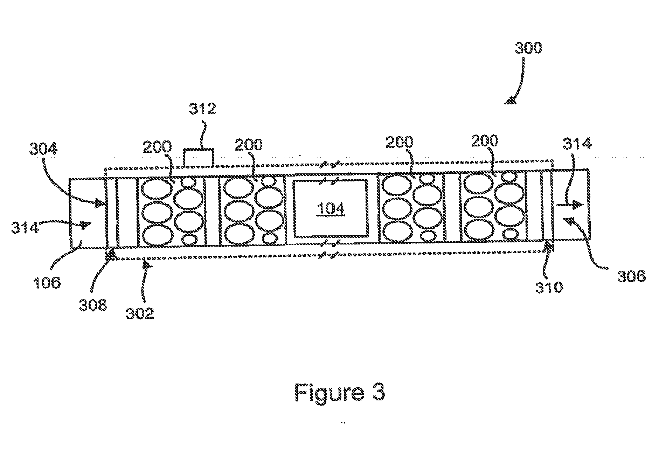

Conveyor 106 has a longitudinal axis that is defined as being aligned with the direction of the arrows shown in Figure 3. Conveyor 106 may be a stationary platform or a moving conveyor. Preferably, it provides support for one or several substrates 104 and presents them to the induction coupled plasma torch 102 at a desired distance according to the induction coupled plasma torch 102 being used. Further, conveyor 106 may move the substrates 104 a distance along the longitudinal axis of the conveyor prior to stopping the movement of the substrates for the deposition of a reaction produce which will be further described below.

Typically, the diameter and height or length of the outer quartz tube 108 and the inner quartz tube 110 maybe any size to fit the desired application of the outer quartz tube 108 and inner quartz tube 110. Preferably, the inner quartz tube 108 has a shorter length than the outer quartz tube 108. Also, the outer quartz tube 108 preferably has a diameter in the range of from about 50 millimeters ("mm") to about 90 mm and a height in the range of from 180mm to about 400 mm. More preferably, the diameter for the outer quartz tube 108 is about 70 mm with a height or length of about 200 mm. Preferably, the inner quartz tube 110 has a diameter in the range of from about 50 mm to about 70 mm and a height in the range of from about 120 mm to about 180 mm. More preferably, the diameter of the inner quartz tube 110 is about 60 mm with a height of about 150 mm.

The induction coupled plasma torch 102 further includes a copper induction coil 114 that is located around the lower portion of the outer quartz tube 108. The coil 114 comprises a plurality of windings 116 having a diameter of approximately in the range of from about 56 mm to about 96 mm. Preferably, the plurality of Windings 116 has a diameter of about 82 mm. Typically, the plurality of windings 116 are spaced apart from each other by a sufficient distance to provide for operation of the induction coupled plasma torch 102. Preferably, the plurality of windings 116 axe spaced apart from each other by about 6 mm. In addition, a gap between the outer quartz tube 108 and the coil 114 can be in a range of from about 2 mm to about 10 mm. Also, the distance between the lowermost portion of the coil 114 and the substrate 104, is designated by "L," which is in the range of from about 30 mm to about 55 mm.

The induction coupled plasma torch 102 further includes a pair of injection ports 118 that are connected to a precursor source chemical line (not shown) carrying the precursor source chemicals to the induction coupled plasma torch 102. With the use of the inner quartz tube 110, the plasma forming gas will have a swirl flow pattern. The source chemicals for deposition of semiconductor thin film material such as silicon will be injected through the injection ports 118, which are preferably located near the lower side of the induction coupled plasma torch 102 and aimed toward the V=0 position for the same reason as disclosed in U.S. Patent No. 6,253,580 issued to Gouskov et al. and U.S. Patent No. 6,536,240 issued to Gouskov et al, both of which are incorporated herein by reference. In one embodiment, the injection ports 118 are connected to the induction coupled plasma, torch 102. In another embodiment, the injection ports 118 are not co.nnected to the induction coupled plasma torch, but are connected to another structural element of the present invention as herein described. In one embodiment, the induction coupled plasma torch 102 is an inductively coupled plasma torch. The injection ports 118 comprise quartz tubing preferably having a diameter in the range of from about 3 mm to about 10 mm, more preferably of about 5 mm, although tubing diameters in other sizes may be used with the induction coupled plasma torch 102. In this embodiment, a pair of injection ports 118 is positioned diametrically across from each other. In another embodiment of the present invention, three or more ports, symmetrically arranged, may be utilized.

Further, induction coupled plasma torch 102 includes a pair of plasma gas inlets 120 that are connected to a plasma gas supply line (not shown) carrying plasma gases to the induction coupled plasma torch 102. The plasma gas inlets 120 enter the induction coupled plasma torch 102 at substantially the same height. Preferably, these plasma gas inlets 120 comprise stainless steel tubing having a diameter of 5 mm, although a range of diameters may suffice for this purpose.

The induction coupled plasma torch 102 is also provided with a coolant inlet 122 and coolant outlet 124. During use, a coolant, such as water, passes through the coolant inlet 122, circulates within the stainless steel chamber 112, and exits through the coolant outlet 124. The coolant inlet 122 and coolant outlet 124 are preferably formed from stainless steel and have a diameter of 5 mm, for example.

The plasma gas inlets 120, the coolant inlet 122 and the coolant outlet 124 are all preferably formed in a stainless steel chamber 112. The chamber 112 is preferably a stainless steel square block 80 mm on a side, and having a height of approximately 40 mm, for example. The chamber 112 is mounted onto the support stand (not shown).

A high frequency generator (not shown) is electrically connected to the coil 114, powering it with a variable power output up to 60 kW at a frequency of 5.2B+/-0.13 MHz. In an embodiment, the generator is Model No. IG 60/5000, available from Fritz Huettinger Electronic GmbH of Germany. This generator is driven with a 50 Hz, 3-phase, 380 V power supply to energize the induction coupled plasma torch 102.

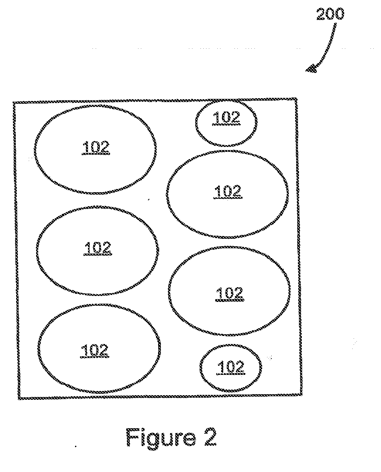

In order to cover a wider deposition width, a group of induction coupled plasma torches 102 are placed together to form a deposition module 200. Figure 2 shows an embodiment 200 of a deposition module that consists of a set of induction coupled plasma torches 102. In addition to a high deposition rate, the deposition module 200 provides uniform deposition thickness. As an example, the deposition module 200 consists of induction coupled plasma, torches 102 having a diameter of 70 mm and two smaller induction coupled plasma torches 102' having a diameter of 35 mm. In this embodiment, deposition module 200 will produce a deposition width of 240 mm with uniform thickness. Other arrangements and sizes of induction coupled plasma torches 102 may be used in a deposition module to provide for a desired deposition width for a particular application.

In one embodiment, the induction coupled plasma torches 102 comprise one row. In another embodiment, the induction coupled plasma torches 102 comprises two or more rows and are positioned in a staggered arrangement as shown in Figure 2 for overlap or to provide even deposition of the reaction product on the substrate 104. As can be seen, these rows are preferably transverse to the longitudinal axis of the conveyor 106. In another embodiment of the present invention, the rows are arranged in another configuration to provide for even deposition of the reaction product on the substrate 104

Deposition modules 200 maybe spaced a distance apart as shown further in Figure 3 or they may be adjacent to each other depending on the desired application. In addition, each deposition module 200 may deposit a specific reaction product on a particular substrate 104 prior to that substrate 104 moving to a subsequent deposition module 200 for depositing of an identical or different reaction product or reaction product. In one embodiment, one deposition module 200 may deposit one type of material or reaction product and another deposition module 200 may deposit another type of material or reaction product. To build layer thickness, multiple deposition modules 200 can be used to deposit the same material. Depending on the design, intrinsic or doped materials can be deposit from different deposition modules 200 that are positioned right above the conveyer 106.

Figure 3 illustrates an embodiment 300 of a plasma deposition apparatus including a deposition chamber 302 for enclosing a plurality of deposition modules 200. This embodiment provides for a continuous deposition process because of the number of deposition modules 200 that are positioned along the conveyor 106. The arrows indicate the longitudinal direction of movement 314 of the conveyer 106. The four deposition modules 200 are lined up inside the deposition chamber to provide a continuous, serial deposition process. The deposition chamber 302 includes an entrance 304 and an exit 306. Located at the entrance 304 is an entrance gas curtain 308 and located at the exit 306 is an exit gas curtain 310 to isolate the outside environment from the inside of the deposition chamber 302. Entrance 304 and exit 306 may be any shape or design to accommodate a desired application. The gas curtains 308 and 310 preferably comprise an inert gas such as argon. Some additional exemplary gases include helium, neon, krypton, xenon, radon, and nitrogen.

The deposition chamber 302 further includes an exhaust system 312 having exhaust ports (not shown) for removing by-product gases, flumes, and particles from the deposition chamber 302. The exhaust system 312 controls the partial pressure within the deposition chamber 302 to ensure optimal deposition conditions. The control of the partial pressure within the deposition chamber 300 may further include providing a negative presssure, such as a vacuum. In another embodiment, the partial pressure may be controlled at or near atmospheric pressure. Any number of exhaust ports may be employed as desired for a specific application. Preferably, the deposition chamber 302 is made of explosive proof materials and also RF shield material to protect the workers.

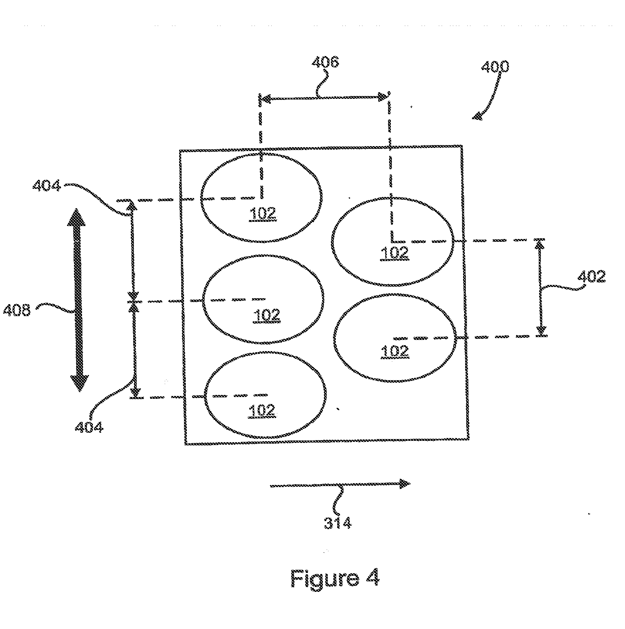

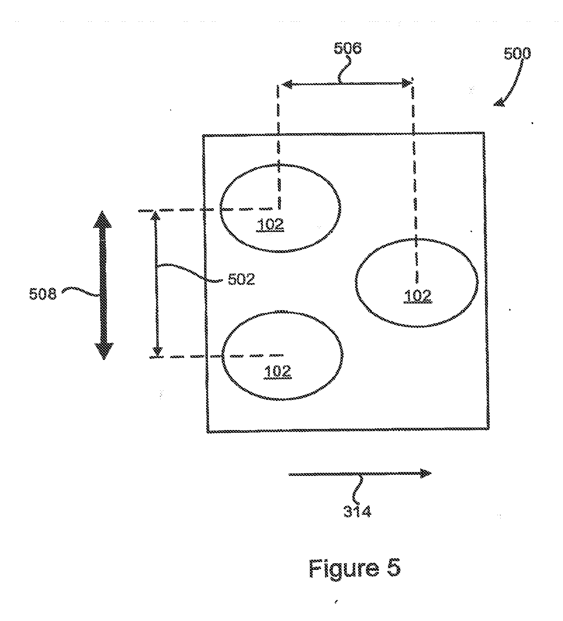

Referring to Figures 4 and 5 illustrate an embodiment 400 and embodiment 500 of a deposition module that consists of a set of induction coupled plasma, torches 102. As shown, deposition module 400 consists of five induction coupled plasma torches 102 having a diameter of 70 mm. Other arrangements and sizes of induction coupled plasma torches 102 may be used in a deposition module to provide for a desired deposition width for a particular application. For example, deposition module 500 consists of three induction coupled plasma torches 102 having a diameter of 70 mm. In these embodiments, deposition modules 400 and 500 will produce a deposition width of approximately 240 mm with uniform thickness.

In one embodiment, a deposition module may include one row of induction coupled plasma torches 102. In another embodiment, a deposition module may include several rows of induction coupled plasma torches 102. Deposition modules 400 and 500 include two rows of induction coupled plasma torches 102 that are positioned in a staggered arrangement as shown in Figures 4 and 5 for overlap, thus providing even deposition of the reaction product on the substrate 104. As can be seen, these rows of induction coupled plasma torches 102 are substantially transverse to the longitudinal axis of the conveyer 106. In another embodiment of the present invention, the rows of induction coupled plasma torches 102 may be arranged in another configuration to provide for a desired deposition result of the reaction product on the substrate 104.

In deposition module 400 as shown in Figure 4, two induction coupled plasma, torches 102 are shown aft of three induction coupled plasma torches 102 relative to the longitudinal direction of movement 314 of the conveyor 106. The center-to-center distance between the two aft induction coupled plasma torches 102 is shown as distance 402 and the center-to-center distance between the three forward induction coupled plasma torches 102 is shown as distance 404. Further, the center-to-center distance between the two rows of induction coupled plasma torches 102 is shown as distance 406. In one embodiment, the distance 402 and 404 are approximately 80 mm and distance 406 is approximately 100 mm. Furthermore, with the oscillation amplitude or distance 408 (discussed further below) being approximately 80 mm, a total uniform deposition width of 320 mm is provided. This is 30% more in width than previously achieved with fewer induction coupled plasma torches 102.

Similarly, in deposition module 500 shown in Figure 5, one induction coupled plasma torch 102 is shown aft of two induction coupled plasma torches 102 relative to the longitudinal direction of movement 314 of the conveyor 106. The center-to-center distance between the two forward induction coupled plasma torches 102 is shown as distance 502. Further, the center-to-center distance between The two rows of induction coupled plasma torches 102 is shown as distance 504. In one embodiment, the distance 502 is approximately 80 mm and the distance 504 is approximately 100 mm. It is noted, that because fewer induction coupled plasma torches 102 are used in deposition module 500 as compared to deposition modules 200 and 400, the spacing between the induction coupled plasma torches 102 is greater. Furthermore, with the oscillation amplitude or distance 508 (discussed further below) being approximately 80 mm, a total uniform deposition width of 240 mm is provided. This embodiment provides for approximately the same deposition width as in embodiment 200 but with fewer number of induction coupled plasma torches 102.

To provide for uniform deposition coverage of a substrate 104, deposition modules 400 and 500 oscillate in a direction 408 that is substantially transverse to the longitudinal direction of movement 314 of the conveyor 106. Thus, the induction coupled plasma torches 102 of deposition modules 400 and 500 are oscillated back and forth across the substrate 104 as it is supported and moved along the longitudinal direction of movement 314 of the conveyor 106. In one aspect, the deposition modules 400 and 500 remain a fixed distance from the substrate 104 during its oscillating motion. In another aspect, the distance between the modules 400 and 500 and the substrate 104 may be variable. This oscillating deposition coverage enables fewer induction coupled plasma torches 102 to be used during a deposition operation. By utilizing fewer induction coupled plasma torches 102, the induction coupled plasma torches 102 may be spaced apart from each other at greater distances when compared to the spacing of the induction coupled plasma toshes 102 of deposition module 200.

The oscillating or reciprocating motion is set to provide the optimal deposition of reaction product on a substmte 104. This oscillating or reciprocating motion has an amplitude and a speed that is variable or fixed to provide the desired deposition results. The amplitude of the oscillating motion of the deposition modules 400 and 500 is generally defined as the distance it oscillates or reciprocates from side to side in the transverse direction 408 relative to the conveyor 106 or substrate 104. Preferably, deposition module 400 will oscillate or reciprocate with an amplitude equal to the distance 402 or 404 depending on which one is larger. Regarding deposition module 500, it will oscillate or reciprocate with an amplitude equal to the distance 502. These are exemplary amplitudes and other amplitudes may be used to achieve a desired deposition result.

Further, deposition modules 400 and 500 will oscillate or reciprocate at a desired frequency. The frequency is typical defined as the number of times the deposition modules 400 and 500 oscillate back and forth across a substrate 104 or conveyor 106 in a given time. In addition, due to the oscillating or reciprocating motion, deposition modules 400 and 500 will travel back and forth across a substrate 104 or conveyor 106 at a desired speed.

Further, the speed and frequency of the oscillating motion may be further determined by the speed of the conveyor 106. For example, if the speed of the conveyor 106 is slower, then the speed and frequency of the oscillating motion may also be slower. Conversely, if the speed of the conveyor 106 is fast, then the speed and frequency of the oscillating motion may also be faster. Moreover, if the speed of the conveyor 106 is varied while the speed and frequency of the oscillating motion remains fixed, then different thicknesses of the reaction product will be achieved on the substrate 104. Also, if fewer induction coupled plasma torches 102 are employed on a particular deposition module, then its amplitude of the transverse direction 408 may be greater. Conversely, if more induction coupled plasma torches 102 are employed on a particular deposition module, then its amplitude of the transverse direction 408 may be less.

Combined, these characteristics of the oscillating motion along the transverse direction 408 provide a desirable deposition result of a reaction product on a substrate 104. These characteristics are set or adjusted prior or during the deposition process to achieve the desired deposition results. For example, deposition module 400 includes fewer induction coupled plasma torches 102 than deposition module 500, thus the spacing of the distances 502 and 504 may be greater than the distances 402, 404, 406 of deposition module 400. Because of these greater distances and fewer induction coupled plasma torches 102, the oscillating motion of deposition module 500 may have a greater speed and frequency than deposition module 400. All of these characteristics of the oscillating motion may be optimized for a particular application to provide an optimal deposition thickness of a reaction product on a particular substrate 104. Typically, the amplitude equals the distance that the deposition modules 400 and 500 travel as herein described, and the frequency time equals the time for a complete oscillation cycle. Thus, an oscillation speed may be calculated by dividing the amplitude by the frequency time.

The distances 402, 404, and 406 maybe the same or different depending on several factors, including desired deposition rate and coverage, deposition thickness, uniformity of deposition, speed of the conveyor 106, number of induction coupled plasma torches 102 used, orientation of the induction coupled plasma torches 102, and the like. Likewise, the distances 502 and 504 maybe the same or different depending on these factors.

Deposition modules 400 and 500 may be spaced a distance apart similarly to deposition modules 200 as shown in Figure 3 or they may be adjacent to each other depending on the desired application. In addition, each deposition module 200, 400, and 500 may deposit a specific reaction product on a particular substrate 104 prior to that substrate 104 moving to a subsequent deposition module 200 for depositing of an identical or different reaction product or reaction product. In one embodiment, one deposition module 200, 400, and 500 may deposit one type of material or reaction product and another deposition module 200, 400, and 500 may deposit another type of material or reaction product. To build layer thickness, multiple deposition modules 200, 400, and 500 can be used to deposit the same material. Depending on the design, intrinsic or doped materials can be deposit from different deposition modules 200, 400, and 500 that are positioned right above the conveyer 106.

In yet another embodiment of the present invention the rows of each deposition module may oscillate or reciprocate relative to each other. For example, referring to Figure 4, the three front induction coupled plasma torches 102 comprising the front row may oscillate or reciprocate relative to the two induction coupled plasma torches 102 of the back row of deposition module 400. In one aspect, the three front induction coupled plasma torches 102 remain stationary while the two back induction coupled plasma torches 102 oscillate or reciprocate the distance or amplitude 402. In another aspect, the three front induction coupled plasma torches 102 may oscillate or reciprocate the distance or amplitude 404 while the two back induction coupled plasma torches 102 remain stationary. In yet another aspect, the front three induction coupled plasma torches 102 may oscillate or reciprocate one-half of the distance or amplitude 404 while the back two induction coupled plasma torches 102 oscillate or reciprocate one-half of the distance or amplitude 402 to provide the desired deposition coverage.

likewise, referring to Figure 5, the two front induction coupled plasma torches 102 comprising the front row may oscillate or reciprocate relative to the induction coupled plasma torch 102 of the back row of deposition module 500. Thus, the rows of induction coupled plasma torches 102 oscillate or reciprocate relative to the other rows of induction coupled plasma torches 102 within a particular deposition module. In one aspect, the two from induction coupled plasma torches 102 comprising the front row may oscillate or reciprocate relative to the two induction coupled plasma torches 102 of the back row of deposition module 400. In one aspect, the two front induction coupled plasma torches 102 remain stationary while the back induction coupled plasma torch 102 oscillates or reciprocates a distance or amplitude. In another aspect, the two front induction coupled plasma, torches 102 may oscillate or reciprocate the distance or amplitude 502 while the back induction coupled plasma torch 102 remains stationary, In yet another aspect, the front two induction coupled plasma torches 102 may oscillate or reciprocate one-half of the distance or amplitude 508 while the back induction coupled plasma torch 102 oscillates or reciprocates one-half of a distance or amplitude to provide the desired deposition coverage.

In yet another embodiment of the present invention, one induction coupled plasma torch 102 may be oscillated like that described above. In this embodiment, the conveyor 106 will move in a step-wise motion and not a continuous motion. For example, the conveyor 106 will move the substrate 104 a distance relative to the deposition module and then the deposition module would oscillate or reciprocate across the substrate 104 beginning on one side and traversing to the other side of the substrate 104. Then the conveyor 106 would move the substrate 104 another distance and stop for another traverse of the substrate surface by the deposition module. The distance of each step is dependent upon the diameter of the induction coupled plasma torch 102. In another aspect of the present invention, a single or plurality of induction coupled plasma torches 102 may make several oscillations or reciprocations across a substrate 104 while depositing a particular reaction product on each pass while the conveyor is moving continuously or step-wise.

The reaction product is produced by the reaction of the precursor gas sources in the presence of the induction coupled plasma torch 102. The induction coupled plasma torch 102 preferably uses an inert plasma source gas to form the plasms where the reaction takes place between the precursor gas source and the induction coupled plasma torch 102 for depositing the reaction product on the substrate 104. Some exemplary plasma source gases include silane, hydrogen, methane, diborane, trimethylborone, phosphine, and mixtures thereof. The precursor gas source may include or be additional forms of matter such as gases, vapors, aerosols small particles, or powders. For example, it is possible to deposit thin film of a few microns in thickness by oscillating or reciprocating the induction coupled plasma torches 102 to cover a width of 1 meter or wider and continuing to move the conveyor to achieve any desired deposition length.

The reaction product is preferably a single element, compound, or mixture of elements or compounds and includes elements and compounds as copper, indium, gallium, slenium, silicon, intrinsic I-type layers, p-type doped silicon layers, and n-type doped silicon. In one embodiment, the reaction product is a copper indium gallium diselenide ("CIGS") layer that is found in solar cells.

The typical solar cell will have p-i-n or n-i-p layer structures. Further, an individual layer for the silicon solar cell can be formed with the following chemicals.

For intrinsic silicon (i-type layer), silane (SiH₄) is the most common material used for these silicon layers. In addition, hydrogen (H₂) gas is also added to the gas stream for making the desired Si: H i-type layer. For p-type doped silicon, either, a SiH₄, CH₄, and B₂H₆ gas mixture or a SiH₄, H₂, and Trimethylboron B(CH₃) ₃ gas mixture may be used, for example. For n-type doped silicon, either a SiH₄ and PH₃ gas mixture or a SiH₄, H₂, and PH₃ gas mixture may be used for example.

The substrate 104 may be any desired size including those sizes commonly known in the art of solar cells. Preferably, the substrate is made from a tin oxide coated glass, such as from Asahi or a molybdenum coated glass, such as Corning 1737, for example.

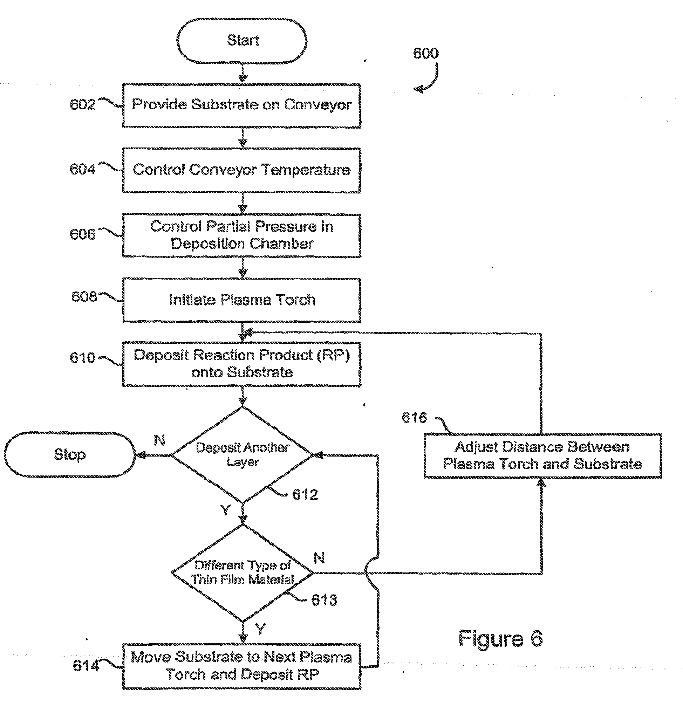

In addition to the aforementioned aspects and embodiments of the present plasma deposition apparatus, the present invention further includes methods for manufacturing these solar cells. Figure 6 illustrates a flow diagram of an embodiment 600 of one such process. In step 602, a substrate 104 or a plurality of substrates 104 are placed on a conveyor 106. In step 604, the temperature of the conveyor 106 is controlled to an appropriate temperature for the optimal deposition of the reaction product onto the substrate 104. In step 606, the partial pressure within the deposition chamber 302 is controlled to provide optimal pressure for deposition of the reaction product onto the substrate 104.

In step 608, the induction coupled plasma torch 102 is initiated. This step can include initiating the flow of the plasma gas supply to the plasma gas inlets 120 and then plasma ignition by supplying electricity to the induction coil 114. In addition, step 608 may also include selecting the precursor gas source to be used to produce the desired reaction product during deposition on the substrate 104 or plurality of substrates 104. Step 608 may also include initiating all the other induction coupled plasma torches 102 if a plurality of them are used such as in deposition modules 200.

In step 610, the induction coupled plasma torch 102 deposits the reaction product onto the substrate 104. In step 612, an inquiry is made as to whether another layer of a reaction product is to be deposited by the induction coupled plasma torth 102. If the response in step 612 is "no," then the process terminates. If the response to this inquiry is "yes," then another inquiry is made in step 613. If the response to the inquiry in step 613 is "no," then the process proceeds to step 616 where the distance between the induction coupled plasma torch 102 and the substrate 104 can be adjusted prior to depositing another thin film layer of reaction product. Preferably, this step is then followed by a return to step 610. As described above, step 610 may include uniformly depositing the thin film reaction product layer with one or more induction coupled plasma torches 102 concurrently. If the response to the inquiry in step 613 is "yes," then in step 614, the conveyor 106 moves the substrate 104 or plurality of substrates 104 along to the next induction coupled plasma torch 102 or plurality of induction coupled plasma torches 102 of deposition module 200 and the next layer of reaction product is deposited on the substrate 104 or plurality of substrates 104. Preferably, the process then proceeds back to step 612 where another inquiry is made regarding whether another layer of reaction product is to be deposited onto the substrate 104 or plurality of substrates 104. This process is repeated until the desired number and types and thicknesses of reaction products have been deposited onto the substrate 104 or plurality of substrates 104.

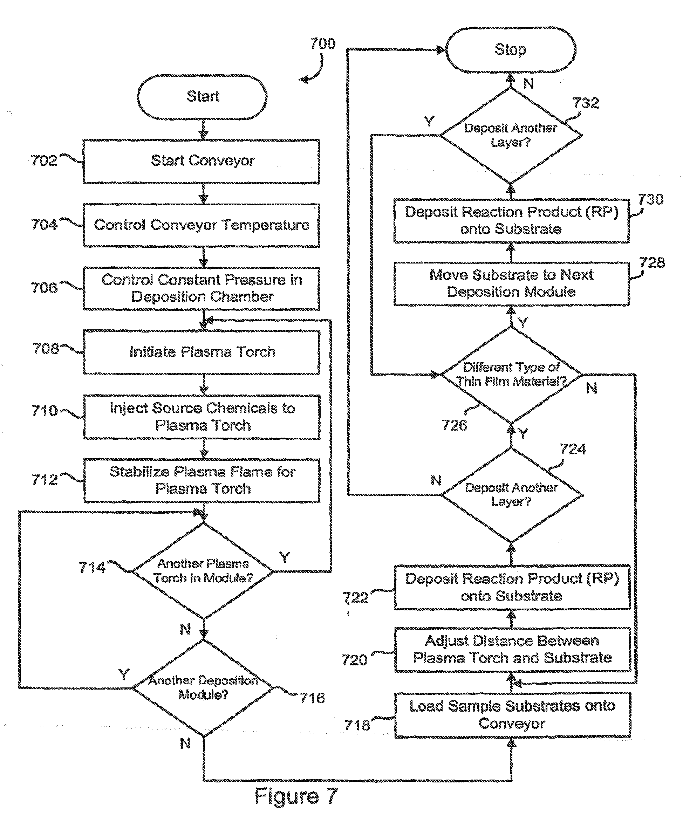

Figure 7 illustrates a flow diagram of an embodiment 700 of another such process. In step 702, the conveyor 106 is started and in step 704 the temperature of the conveyor 106 is controlled to an appropriate temperature for the optimal deposition of the reaction product onto the substrate 104. In step 706, the pressure within the deposition chamber 302 is controlled to provide optimal pressure for deposition of the reaction product onto the substrate 104.

In step 708, the induction coupled plasma torch 102 or pluratity of induction coupled plasma torches 102 are initiated. This step can include initiating the flow of the plasma gas supply to the plasma gas inlets 120 and then plasma ignition by supplying electricity to the induction coil 114. In addition, step 708 may also include selecting the precursor gas source to be used to produce the desired reaction product during deposition on the substrate 104 or plurality of substrates 104.

In step 710, the precursor gas source is injected into the induction coupled plasma torch 102 or plurality of induction coupled plasma torches 102. In one embodiment, the flow of the precursor gas source may be set or optimized by measuring off-line the thicknesses, composition, and/or performance of substrates 104 that have already been deposited with a reaction product layer. If the thicknesses, composition, and/or performance is not within design standards, then the precursor gas source and/or the flow rate of the precursor gas source can be adjusted accordingly. In step 712, the plasma flame of the induction coupled plasma, torch 102 or plurality of induction coupled plasma torches 102 is stabilized.

In step 714, an inquiry is made as to whether additional induction coupled plasma torch 102 or plurality of induction coupled plasma torches 102 are to be initiated and stabilized. If so, then the process preferably returns to step 708 to initiate the induction coupled plasma touch 102 or plurality of induction coupled plasma torches 102 or deposition modules 200. If the answer to the inquiry in step 714 is "no," then another inquiry is made in step 716. In this inquiry, additional deposition modules 200 may be initiated and stabilized. If the answer to this inquiry is "no," then the process preferably proceeds to step 718 where the substrates 104 are loaded onto the conveyor 106. This is followed by step 720, where the distance between the induction coupled plasma torch 102 or plurality of induction coupled plasma torches 102 and the substrates 104 may be adjusted.

In step 722, the induction coupled plasma torch 102 or plurality of induction coupled plasma torches 102 of the deposition modules 200 deposit the reaction product onto the substrate 104. In step 724, an inquiry is made as to whether another layer of a reaction product is to be deposited by the induction coupled plasma torch 102 or plurality of induction coupled plasma torches 102. If the response in step 724 is "no," then the process preferably terminates. If the response in step 724 is "yes," then another inquiry is made in step 726. In step 726, an inquiry is made as to whether a different thin film layer of reaction product is to be deposited on substrate 104. If the response to this inquiry is "no," then preferably the process returns to step 720 to adjust distance between the induction coupled plasma, torch 102 or plurality of induction coupled plasma torches 102 and the substrate 104 or plurality of substrates 104, followed by deposition of another reaction product layer in step 722. If the response to the inquiry in step 726 is "yes," then in step 728 the conveyor 106 preferably moves the substrate 104 or plurality of substrates 104 along to the next induction coupled plasma torch 102 or plurality of induction coupled plasma torches 102 or deposition module 200. Then in step 730, the induction coupled plasma torch 102 or plurality of induction coupled plasma torches 102 deposit or deposition module 200 deposits the next layer of reaction product on the substrate 104 or plurality of substrates 104.

In step 732, another inquiry is made as to whether another thin film layer of reaction product is to be deposited. If the response to this inquiry is "yes," then the process preferably returns to step 726. If the response to this inquiry is "no," then the process preferably terminates and the substrates 104 or plurality of substrates 104 are removed from the conveyor 106.

In another aspect of the present methods for manufacturing solar cells, the substrates 104 may be removed from the process at other times than described above to measure the thicknesses, compositions, and/or performance of the deposition process to determine whether to adjust any of the process parameters describe above, such as conveyor temperature, deposition chamber pressure, composition of the precursor gas source, and/or the flow rate of the precursor gas source to one or more of the induction coupled plasma torch 102 or plurality of induction coupled plasma torches 102 or deposition modules 200.

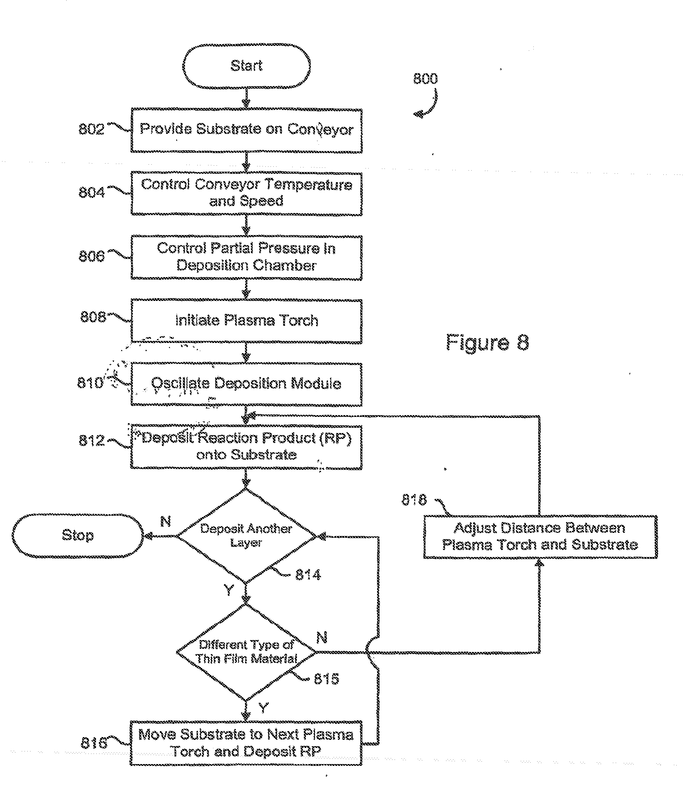

Figure 8 illustrates a flow diagram of an embodiment 800 of another such process. In step 802, the conveyor 106 is started and in step 804 the speed and temperature of the conveyor 106 is controlled to an appropriate temperature for the optimal deposition of the reaction product onto the substrate 104. In step 806, the pressure within the deposition chamber 302 is controlled to provide optimal pressure for deposition of the reaction product onto the substrate 104.

In step 808, the induction coupled plasma torch 102 or plurality of induction coupled plasma torches 102 are initiated. This step can include initiating the flow of the plasma gas supply to the plasma gas inlets 120 and then plasma ignition by supplying electricity to the induction coil 114. In addition, step 808 may also include selecting the precursor gas source to be used to produce the desired reaction product during deposition on the substrate 104 or plurality of substrates 104.

In step 810, one or more of the deposition modules 400 and 500 are oscillated or reciprocated in a transverse to provide an amplitude, speed, and frequency sufficient to provide desired deposition coverage across the substrate 104 or plurality of substrates 104. In step 812, the precursor gas source is injected into the induction coupled plasma torch 102 or plurality of induction coupled plasma torches 102. In one embodiment, the flow of the precursor gas source may be set or optimized by measuring off-line the thicknesses, composition, and/or performance of substrates 104 that have already been deposited with a reaction product layer. If the thicknesses, composition, and/or performance is not within design standards, then the precursor gas source and/or the flow rate of the precursor gas source can be adjusted accordingly. The plasma flame of the induction coupled plasma torch 102 or plurality of induction coupled plasma torches 102 is stabilised.

In step 814, an inquiry is made as to whether another layer of a reaction product is to be deposited by the induction coupled plasma torch 102 or plurality of induction coupled plasma torches 102. If the response in step 814 is "no," then the process preferably terminates. If the response in step 814 is "yes", then another inquiry is made in step 815. In step 815, an inquiry is made as to whether a different thin film layer of reaction product is to be deposited on substrate 104. If the response to this inquiry is "no," then preferably the process returns to step 818 to adjust distance between the induction coupled plasma, torch 102 or plurality of induction coupled plasma torches 102 and the substrate 104 or plurality of substrates 104, followed by deposition of another reaction product layer in step 812. If the response to the inquiry in step 815 is "yes," then in step 816 the conveyor 106 preferably moves the substrate 104 or plurality of substrates 104 along to the next induction coupled plasma torch 102 or plurality of induction coupled plasma torches 102 of deposition module 400 and 500. Then in steps 814, 815, 818, and 812 the induction coupled plasma torch 102 or plurality of induction coupled plasma torches 102 deposit or deposition module 400 and 500 deposits the next Layer of reaction product on the substrate 104 or plurality of substrates 104.

In another aspect of the present methods for manufacturing solar cells, the substrates 104 may be removed from the process at other times than described above to measure the thicknesses, compositions, and/or performance of the deposition process to determine whether to adjust any of the process parameters descried above, such as conveyor temperature, deposition chamber pressure, composition of the precursor gas source, and/or the flow rate of the precursor gas source to one or more of the induction coupled plasma torch 102 or plurality of induction coupled plasma torches 102 or deposition modules 400 and 500.

Although there has been described what is at present considered to be the preferred embodiments of the plasma deposition apparatus and methods for making solar cells, it will be understood that the present plasma deposition apparatus can be embodied in other specific forms without, departing from the spirit or essential characteristics thereof. For example, additional plasma torches or different combinations of deposition modules, other than those described herein could be used without departing from the spirit or essential characteristics of the present plasma deposition apparatus and methods for making solar cells, The present embodiments are, therefore, to be considered in all aspects as illustrative and not restrictive. The scope of the invention is indicated by the appended claims rather than the foregoing description.

## Claims

1. A method for forming a layer of solar cells on a substrate in a deposition chamber comprising:
supporting said substrate;
providing a high frequency induction coupled plasma torch comprising a coil, said
induction coupled plasma torch being selected positionable along the surface area of one side of said substrate, a distance of 30 - 55 mm separating said coil from said substrate;
introducing a plasma, gas consisting essentially of an inert gas into said high frequency
induction coupled plasma torch to form a plasma within said coil;
injecting a precursor chemical source into said high frequency induction coupled
plasma torch; and
depositing a reaction product of said induction coupled plasma torch and said
precursor gas source onto said substrate while maintaining spacing between said substrate and said coil.

2. A method for forming a layer of solar cells on at least one substrate in a deposition chamber comprising:
supporting said at least one substrate on a conveyor having a axis;
providing at least two modules spaced apart from each other along said longitudinal
axis of said conveyor, each of said at least two modules having at least one plasma torch for depositing a reaction product on said at least one substrate, said at least one plasma torch located a distance from said at least one substrate, said at least one plasma torch comprising a coil, said induction coupled plasma torch being selected positionable along the surface area of one side of said substrate, a distance of 30 - 55 mm separating said coil from said substrate;
introducing a plasma gas consisting essentially of an inert gas into said high frequency
induction coupled plasma torch to form a plasma within said coil;
injecting a precursor chemical source into said high frequency induction coupled
plasma torch;
depositing a reaction product of said induction coupled plasma torch and said
precursor gas source onto said substrate while maintaining spacing between said substrate and said coil; and
transporting said at least one substrate along said longitudinal axis.

3. The method for forming a layer of solar cells on a substrate of claim 1 or claim 2 further comprising adjusting the partial pressure within said chamber.

4. The method for forming a layer of solar cells on a substrate of claim. 1 or claim 2 further comprising evacuating the partial pressure in said chamber.

5. The method for forming a layer of solar cells on a substrate of claim. 1 or claim 2 further comprising controlling the partial pressure within said chamber.

6. The method for forming a layer of solar cells on a substrate of claim 1 or claim 2 further comprising controlling the temperature of said substrate to maintain optimum deposition temperature of said reaction product on said substrate.

7. The method for forming a layer of solar cells on a substrate of claim 1 or claim 2 wherein said reaction product is selected from the group consisting of thin film layers of pure and doped silicon and copper indium gallium diselenide (CIGS).

8. A plasma deposition apparatus for making solar cells comprising:
means for supporting a substrate;
means for supplying reactants;
plasma torch means for depositing a product on said substrate, said plasma torch
means located a distance from said substrate; and
means for oscillating said plasma torch means relative to said substrate.

9. A method for forming a layer of solar cells on at least one substrate in a deposition chamber comprising:
supporting a substrate;
supplying reactants;
depositing a product on said substrate with a plasma torch means, said plasma torch
means located a distance from said substrate; and
oscillating said plasma torch means relative to said substrate.

10. The plasma deposition apparatus for making solar cells of claim 8 or the method for forming a layer of solar cells on at least one substrate of claim 9 wherein said deposited solar cells are silicon thin film solar cells, for example copper indium gallium diselenide (CIGS) thin film solar cells.

11. The plasma deposition apparatus for making solar cells of claim 8 or the method for forming a layer of solar cells on at least one substrate of claim 9 wherein said reactants can in a form selected from the group consisting of a gas, vapor, aerosol, small particle, or powder.

12. The plasma deposition apparatus for making solar cells of claim 8 or the method for forming a layer of solar cells on at least one substrate of claim 9 wherein said plasma forming gas is argon gas.

13. The plasma deposition apparatus for making solar cells of claim 8 or the method for forming a layer of solar cells on at least one substrate of claim 9 wherein said product is produced by a gas selected from silane, hydrogen, methane, diborane, trimethylborone, phosphine and mixtures thereof.

14. The plasma deposition apparatus for making solar cells of claim 8 or the method for forming a layer of solar cells on at least one substrate of claim 9 wherein said product is produced from reactants containing chemicals selected from group consisting of copper, indium, gallium, selenium, and mixtures thereof.

15. The plasma deposition apparatus for making solar cells of claim 8 or the method for forming a layer of solar cells on at least one substrate of claim 9 wherein said substrate is selected from the group consisting of tin oxide coated glass and molybdenum coated glass.

16. The plasma deposition apparatus for making solar cells of claim. 8 or the method for forming a layer of solar cells on at least one substrate of claim 9 wherein said distance is between said plasma torch means and said substrate is about 30 - 55 mm.
